# EUROPÄISCHE PATENTSCHRIFT

(11) **EP 2 853 863 B1**
(45) Veröffentlichungstag und Bekanntmachung des Hinweises auf die Patenterteilung: **01.03.2017**
(21) Anmeldenummer: 13185881.3
(22) Anmeldetag: 25.09.2013
(51) Int. Cl.: G01D 11/24, H05K 5/06

(54) **Sensor mit einem Zugangselement für dessen Gehäuse**
Sensor with an access element for its housing
Capteur comprenant un élément d'accès pour son boîtier

(43) Veröffentlichungstag der Anmeldung: 01.04.2015
(73) Patentinhaber: BAUMER ELECTRIC AG, 8500 Frauenfeld (CH)
(72) Erfinder: Hohl, Michael, 8405 Winterthur (CH)
(74) Vertreter: Strauss, Steffen

(56) Entgegenhaltungen:
- EP-A1- 2 461 137
- EP-A2- 2 615 892
- DE-A1- 2 943 082
- DE-U1- 8 202 016
- DE-U1- 8 415 992

## Beschreibung

Die Erfindung betrifft Sensoren mit kontaktlos betätigbaren, innerhalb eines Gehäuses angeordneten Auslösern.

Es ist bekannt, bestimmte Sensoren nach dem Einbau anzulernen. So kann zum Beispiel ein Füllstandssensor lernen, welcher Füllstandswert als voll und welcher Füllstandswert als leer zu interpretieren ist. Um diesen Anlernvorgang, der auch als Teach-In bekannt ist, auszulösen, sind aus der EP 2 461 137 A1 und der EP 2 461 138 A1 als Hallsensoren bzw. als induktive Sensoren ausgebildete Auslöser bekannt, mit denen ein Anlernvorgang z.B. dadurch ausgelöst werden kann, dass ein Schraubendreher vor den Auslöser gehalten wird. Nachteilig bei den bisherigen Sensoren ist jedoch, dass die Auslöser an einer Außenfläche des Gehäuses oder direkt hinter dem Gehäuse angebracht sein müssen, was bei manchen Sensoren dazu führt, dass die Auslöser zum Beispiel an schwer zugänglichen Stellen angebracht werden müssen, da eine Anbringung an anderen Positionen aufgrund der Konstruktion des Sensors nicht möglich ist. Ferner ist auch die Anbringung hinter metallischen Gehäusen, wie sie in rauen Umgebungen oft benutzt werden, nicht möglich, da diese den Auslöser abschirmen.

Aufgabe der Erfindung ist es, eine Lösung bereitzustellen, mit der der Einbau von Auslösern variabler gestaltet werden kann.

Gelöst wird diese Aufgabe durch einen Sensor gemäß Anspruch 1. Der Sensor umfasst ein Zugangselement zur Anbringung in einer Öffnung eines Gehäuses des Sensors mit einem kontaktlos betätigbaren, innerhalb des Gehäuses angeordneten Auslöser, wobei das Zugangselement eine nach außen offene Ausnehmung mit einem starren Boden ausbildet und eine durchgängig geschlossene, die Ausnehmung bis auf den Boden und die Öffnung umschließende Wandung aufweist, wobei der starre Boden mit der durchgängig geschlossenen Wandung aus einem einzigen Teil besteht.

Mit einem solchen Zugangselement ist es möglich, den Auslöser variabel innerhalb des Gehäuses zu positionieren. Der Zugang zum Auslöser wird durch die Ausnehmung sichergestellt. Im montierten Zustand ragt die Ausnehmung des Zugangselementes in das Innere des Gehäuses hinein, um ein Auslösen zu gewährleisten. Um zu verhindern, dass ein Gegenstand, wie ein Schraubenzieher, Beschädigungen verursacht, weist die Ausnehmung einen starren Boden auf.

Um eine innen liegende Elektronik vor Schmutz zu schützen, weist das Zugangselement eine durchgängig geschlossene, die Ausnehmung bis auf den Boden und die Öffnung umschließende Wandung auf, wobei der starre Boden mit der durchgängig geschlossenen Wandung aus einem einzigen Teil besteht. Eine solche Ausgestaltung ist leicht herzustellen und zu montieren und stellt darüber hinaus eine sichere Trennung des Innenraums des Gehäuses von der Umgebung sicher. Auf weitere Dichtungselemente innerhalb des Zugangselementes kann verzichtet werden. Auch sehr dünnflüssige oder kriechfähige Verschmutzungen können bei dieser Ausgestaltung nicht durch das Zugangselement in den Innenraum eindringen.

Die erfindungsgemäße Lösung kann mit den folgenden weiteren, jeweils für sich vorteilhaften Ausgestaltungen beliebig kombiniert und weiter verbessert werden.

Um beispielsweise das Risiko eines unbeabsichtigten Auslösens zu verringern und den benötigten Bauraum klein zu halten, kann die Ausnehmung langgestreckt sein und eine Längserstreckung aufweisen, Als Längserstreckung ist die größte Ausdehnung der Ausnehmung in das Sensorinnere anzusehen. Sie kann zweimal so lang sein wie die Erstreckungen senkrecht dazu. Um eine gute Herstellbarkeit zu gewährleisten, kann als obere Grenze ein Verhältnis von 50:1 angesehen werden, d.h., dass die Längserstreckung maximal fünfzigmal so lang ist wie die dazu senkrechten Erstreckungen. Um ein Einführen des Auslöseorgans nicht unnötig schwer zu gestalten, sollte das Verhältnis nicht größer als 20:1 sein. In der Praxis dürfte ein maximales Verhältnis von 10:1 einen guten Kompromiss aus einfacher Bedienbarkeit, Sicherheit vor unbeabsichtigtem Auslösen und guter Herstellbarkeit gewährleisten.

Die Längserstreckung kann gerade verlaufen. Beispielsweise kann die Ausnehmung zylindrisch oder prismatisch ausgestaltet sein. Bei einer zylindrischen oder prismatischen Ausgestaltung verläuft die Ausnehmung gerade mit einer gleichbleibenden Grundfläche entlang einer Richtung.

In einer vorteilhaften Ausgestaltung ist die Ausnehmung sacklochartig ausgeformt. Eine sacklochartig ausgeformte Ausnehmung kann beispielsweise durch Bohren eines Sackloches erzeugt werden. Alternativ kann eine solche Ausnehmung beispielsweise bei einem Spritzgießverfahren mit einfachen Mitteln hergestellt werden.

Vorteilhafterweise kann die Ausnehmung als Führung, insbesondere als kodierte Führung für ein Auslöseorgan ausgeformt sein. Beispielsweise kann die Ausnehmung einen sechseckigen Querschnitt aufweisen, der das Einführen eines Sechskantschlüssels ermöglicht. Alternativ zu einer Ausgestaltung für ein gängiges Werkzeug kann die Ausnehmung auch so ausgeformt sein, dass nur ein spezielles Auslöseorgan, das zum Beispiel speziell für einen einzigen Sensor gefertigt wird, eingeführt werden kann. Ein unbeabsichtigtes oder unautorisiertes Auslösen kann dadurch verhindert werden.

Bei einigen Auslösern erfolgt ein optisches Feedback, um das Auslösen des Anlernvorgangs zu bestätigen. In einer vorteilhaften Ausgestaltung weist ein Zugangselement ein Lichtleitelement auf. Wenn das Zugangselement am Gehäuse angebracht ist, kann das Lichtleitelement vor einem Licht emittierenden Element, beispielsweise einer LED, beginnen und das von dem Licht emittierenden Element ausgehende Licht bis zur Außenseite des Gehäuses weiterleiten, um den Benutzer ein optisches Feedback zu geben.

Um Platz zu sparen kann in einer vorteilhaften Ausgestaltung das Lichtleitelement neben der Ausnehmung entlang verlaufen. Es kann beispielsweise parallel zu einer Längserstreckung des Zugangselementes verlaufen.

Das Lichtleitelement kann von einem Teil einer Wandung ausgebildet sein. Dies führt zu einer kompakten Ausgestaltung des Zugangselementes und verringert das Risiko von Beschädigungen, beispielsweise das Risiko, dass das Lichtleitelement beim Einführen vom Zugangselement abgetrennt wird.

In einer vorteilhaften Ausgestaltung ist das Lichtleitelement einteilig mit einer Wandung. Beispielsweise kann die Wandung aus einem Licht leitenden Material bestehen. Sie kann so ausgestaltet sein, dass sie das von dem Licht emittierenden Element ausgesandte Licht möglichst effizient nach außen leitet, beispielsweise durch Bündelung und/oder Reflexion. Die Wandung kann dazu beispielsweise nach Art einer Linse konvex oder konkav ausgestaltete Bereiche aufweisen.

Das Zugangselement kann aus einem transparenten Material, insbesondere aus einem transparenten Kunststoff bestehen. Bei einem so ausgestalteten Zugangselement können eine Wandung oder andere Elemente automatisch als Lichtleitelemente dienen. Das Zugangselement kann auch nur teilweise aus einem transparenten Material bestehen, beispielsweise im Bereich einer Wandung. Ist ein optisches Feedback nicht notwendig, kann das Zugangselement aus einem nichttransparenten Material bestehen. Beispielsweise könnte es aus einem Metall, vorzugsweise aus einem nichtferromagnetischen Metall, bestehen. Ein solches metallisches Zugangselement kann eine hohe Stabilität gewährleisten. Steht zum Beispiel eine kostengünstige Fertigung im Vordergrund, so kann das Zugangselement aus einem Kunststoff bestehen. Es kann beispielsweise mittels eines Spritzgussverfahrens hergestellt werden.

Das Zugangselement kann in einer bevorzugten Ausgestaltung formstabil sein. Dadurch ist gewährleistet, dass beim Einführen eines Auslöseorgans der vor dem Boden liegende Auslöser nicht beschädigt wird. Insbesondere kann das Zugangselement also formstabil in einer Einführrichtung eines Auslöseorgans sein. Vorteilhafterweise ist es in allen Richtungen formstabil, um zu vermeiden, dass z.B. durch seitliche Bewegungen beim Einführen andere Elemente in dem Gehäuse beschädigt werden.

Um ein Auslösen des Auslösers zu ermöglichen, wenn das Auslöseorgan nicht komplett in die Ausnehmung eingeführt ist, kann das Zugangselement ein Flussleitelement aufweisen, das die Ausnehmung zumindest teilweise, bevorzugt komplett ausfüllt. Ein solches Flussleitelement kann beispielsweise aus einem ferromagnetischen Material bestehen, das das Magnetfeld eines Auslöseorgans zum Auslöser weiterleitet.

Ein Flussleitelement kann vom Rest des Zugangselementes lösbar sein. Beispielsweise kann es in eine Ausnehmung einsetzbar sein. Bei einer prismatischen oder zylindrischen Ausgestaltung der Ausnehmung kann das Flussleitelement entsprechend prismatisch oder zylindrisch ausgestaltet sein und in die Ausnehmung einschiebbar sein. In einer anderen Ausgestaltung kann das Flussleitelement von einer Schraube gebildet werden, die in eine Ausnehmung mit einem Gewinde eingeschraubt werden kann. In einer weiteren vorteilhaften Ausgestaltung kann das Flussleitelement fest mit dem Rest des Zugangselementes verbunden sein. Beispielsweise kann es von einem Kunststoff umspritzt worden sein und fest im Zugangselement angebracht sein.

Das Flussleitelement kann im eingesetzten Zustand plan oder fluchtend mit der Oberfläche einer Basis des Zugangselementes und/oder mit der Außenseite des Gehäuses sein. Dadurch wird der benötigte Bauraum für den Sensor nicht vergrößert.

Um ein sicheres Auslösen und eine einfache Konstruktion zu ermöglichen, liegt der starre Boden vor dem Auslöser. Der Auslöser wird so durch den starren Boden vor Beschädigungen geschützt.

Der starre Boden des Zugangselementes kann plan ausgestaltet sein, insbesondere kann er plan an der Außenseite sein, die vor dem Auslöser liegt. Dadurch ist eine gleichmäßige Auslösung auch bei leicht abweichenden Montagepositionen des Zugangselementes gewährleistet. Auch an der Innenseite kann der starre Boden plan sein. In einer alternativen Ausgestaltung kann der starre Boden auch komplementär zur Spitze eines Auslöseorgans ausgestaltet sein. Dadurch wird ein Auslösen mit einem falschen Gegenstand verhindert.

Die Ausnehmung kann eine Längserstreckung aufweisen, die bezüglich des Gehäuses von außen nach innen verläuft, wenn das Zugangselement am Gehäuse angebracht ist. Die Längserstreckung kann insbesondere zum Auslöser hin verlaufen. Eine solche Ausgestaltung ist besonders raumsparend, da auf den Seiten des Zugangselementes so wenig Platz wie möglich beansprucht wird. Dieser Platz kann für andere Teile des Sensors genutzt werden.

Die Ausnehmung kann eine Längserstreckung aufweisen, die senkrecht zu der Außenseite des Gehäuses verläuft, wenn das Zugangselement am Gehäuse angebracht ist. Bei einem senkrechten Zugang beansprucht die Ausnehmung weniger Platz als zum Beispiel bei einer schrägen Ausgestaltung.

Um die Bauform des Sensors nicht zu vergrößern, kann das Zugangselement eine Basis aufweisen, die mit einer Oberfläche eines Gehäuses fluchtend zusammengefügt ist. Beispielsweise kann eine solche Basis in eine Öffnung des Gehäuses eingepresst oder eingeschraubt oder mit einem zusätzlichen Element wie einem Sprengring, einer Schraubenmutter oder mit Klebstoff gegen Herausfallen gesichert sein. Die Basis kann breiter als der Rest der Ausnehmung sein. Dadurch ist eine Montage des Zugangselementes von außen möglich. Der Rest des Zugangselementes kann einfach in das Gehäuse eingeschoben werden, bis die Basis am Gehäuse anschlägt.

Um eine möglichst dichte Verbindung mit dem Gehäuse herstellen zu können, kann das Zugangselement eine Basis aufweisen, die mit der Öffnung des Gehäuses abdichtend zusammengefügt ist. Dies kann etwa durch eine komplementäre Ausgestaltung der Basis zu der Öffnung gewährleistet sein. Ferner kann zwischen der Basis und der Öffnung ein Dichtelement, beispielsweise ein O-Ring, angebracht sein. Ein solches Dichtelement kann beispielsweise durch auftretende Presskräfte komprimiert sein und dadurch seine Dichtwirkung entfalten. In einer alternativen Ausgestaltung ist die Basis sehr breit und formt eine Außenseite des Gehäuses, die mit den anderen Außenseiten unter Bildung des Gehäuses zusammengefügt ist.

Ein Bausatz für ein Gehäuse eines erfindungsgemäßen Sensors umfasst ein erfindungsgemäßes Zugangselement. Ein erfindungsgemäßer Sensor umfasst ein Gehäuse, in das ein erfindungsgemäßes Zugangselement eingesetzt ist.

Im Folgenden wird die Erfindung anhand vorteilhafter Ausführungen mit Bezug auf die Zeichnungen beispielhaft näher erläutert. Die beschriebenen Ausführungsformen stellen dabei lediglich mögliche Ausgestaltungen dar, bei denen jedoch die einzelnen Merkmale, wie oben beschrieben, unabhängig voneinander kombiniert oder weggelassen werden können. Gleiche Bezugszeichen stehen dabei in den verschiedenen Zeichnungen jeweils für gleiche Gegenstände.

Es zeigen:
- Fig. 1: eine schematische Schnittansicht eines Gehäuses eines Sensors mit einem Zugangselement, in das ein Auslöseorgan eingeführt werden kann;
- Fig. 2: eine schematische Schnittansicht eines Gehäuses eines Sensors mit einem Zugangselement, in das ein Flussleitelement eingesetzt ist;
- Fig. 3: eine schematische Perspektivdarstellung eines erfindungsgemäßen Sensors;
- Fig. 4: eine schematische Perspektivansicht eines erfindungsgemäßen Zugangselementes.

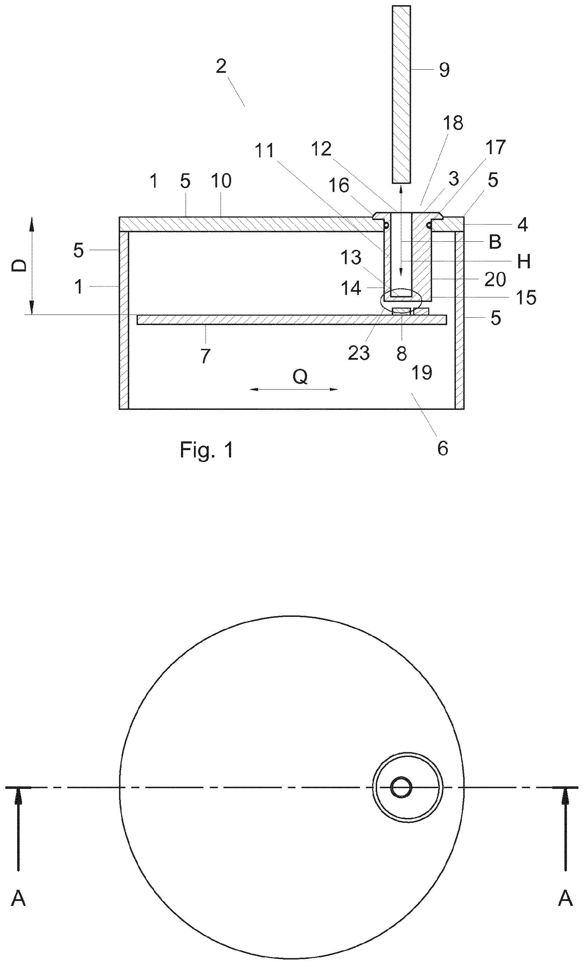

Fig. 1 zeigt einen Querschnitt durch ein Gehäuse 1 eines Sensors 2, in das ein Zugangselement 3 eingebracht ist. Das Gehäuse 1 definiert durch seine Außenseiten 5 eine Kontur 4. In einem Innenraum 6 des Gehäuses ist auf einer Platine 7 ein Auslöser 8 angeordnet. Der Auslöser 8 kann kontaktlos betätigt werden. Es kann sich beispielsweise um einen induktiv messenden Sensor oder um einen Hallsensor handeln, der auf eine Änderung eines Magnetfeldes bzw. auf ein Magnetfeld reagiert. Um den Auslöser 8 zu betätigen, wird ein ferromagnetisches Auslöseorgan 9 in die Nähe des Auslösers 8 gebracht. Befindet sich das Auslöseorgan 9 innerhalb eines Auslösebereiches 23, so wird der Auslöser 8 betätigt und ein Anlernmodus des Sensors 2 initiiert. Bei dem Auslöseorgan 9 kann es sich um ein dediziertes Auslöseorgan 9 oder auch nur um ein Werkzeug wie einen Schraubendreher handeln.

Die Platine 7 befindet sich in einem Abstand D von einer oberen Außenseite 10. Um den Auslöser 8 zu betätigen, verfügt das Gehäuse 1 über ein Zugangselement 3, das den Zugang zum Auslöser 8 ermöglicht. Das Zugangselement 3 weist eine Ausnehmung 11 auf, die durch die Kontur 4 des Gehäuses 1 hindurch in das Innere des Gehäuses hineinragt. An der der Außenseite 10 des Gehäuses 1 zugeordneten Seite weist das Zugangselement 3 eine Öffnung 12 auf. Der Öffnung 12 liegt ein starrer Boden 13 gegenüber, der vor dem Auslöser 8 liegt. Das Auslöseorgan 9 kann durch die Öffnung 12 in die Aufnahme 11 eingeführt werden und entlang der Bewegungsrichtung B in Richtung des Auslösers 8 bewegt werden. Um zu verhindern, dass das Auslöseorgan 9 den Auslöser 8 beschädigt, verfügt das Zugangselement 3 über einen starren Boden 13.

Das Zugangselement 3 weist eine durchgängig geschlossene Wandung 14 auf, die die Ausnehmung 11 bis auf den starren Boden 13 und die Öffnung 12 umschließt und den Innenraum 6 des Gehäuses 1 von der Umgebung trennt. Die durchgängig geschlossene Wandung 14 besteht hier aus einem einzigen Teil. Seitliche Elemente 15 sind einteilig mit dem starren Boden 13 und einer Basis 16, die an der oberen Außenseite 10 des Gehäuses angeordnet ist. Das Zugangselement 3 kann bei einer solchen Ausgestaltung besonders leicht angefertigt werden. Es kann beispielsweise ein Spritzgussteil sein. Aufgrund der einteiligen Ausgestaltung ist ein Zusammenfügen von Elementen nicht notwendig. Die durchgängig geschlossene Wandung 14 des Zugangselementes 3 stellt sicher, dass kein Schmutz oder keine Flüssigkeiten von außen in den Innenraum 6 des Gehäuses 1 eindringen können. Um auch die Verbindung zwischen der oberen Außenseite 10 des Gehäuses 1 und dem Zugangselement 3 abzudichten, ist zwischen dem Zugangselement 3 und der oberen Außenseite 10 ein Dichtelement 17 in Form eines O-Ringes angebracht. Die Basis 16 ist also abdichtend mit einer Öffnung 18 in der oberen Außenseite 10 des Gehäuses 1 zusammengefügt.

Ferner ist die Basis 16 des Zugangselementes 3 so ausgestaltet, dass sie mit der oberen Außenseite 10 des Gehäuses 1 fluchtet. In Fig. 1 ist gezeigt, dass die Oberfläche der Basis 16 und die Oberfläche der oberen Außenseite 10 ineinander übergehen. Beide sind plan. Durch diese Ausgestaltung verändert sich die äußere Bauform des Gehäuses 1 nicht. Das Gehäuse 1 weist die gleiche Kontur 4 wie ein Gehäuse 1 ohne ein Zugangselement 3 auf.

Eine Längserstreckung H der Ausnehmung 11, die hier identisch mit der Bewegungsrichtung B des Auslöseorgans ist, verläuft von außen nach innen. Eine Ausdehnung des Zugangselementes 3 in einer Querrichtung Q, die hier parallel zu einer Oberfläche der oberen Außenseite 10 ist, kann dadurch möglichst gering gehalten werden.

Die Längserstreckung H verläuft senkrecht zur oberen Außenseite 10 des Gehäuses 1. In einer alternativen Ausgestaltung könnte die Längserstreckung H auch schräg zu dieser Oberfläche verlaufen. Dadurch würde das Zugangselement 3 jedoch mehr Platz beanspruchen.

Die Ausnehmung 11 ist sacklochartig ausgeformt. Sie beginnt an der Öffnung 12 und endet am starren Boden 13. Dazwischen ist sie von den seitlichen Elementen 15 umschlossen.

Die Ausnehmung 11 ist zylindrisch, insbesondere kreiszylindrisch. An der Öffnung 12 weist sie einen kreisförmigen Querschnitt auf, der sich geradlinig bis zum starren Boden 13 fortsetzt. In einer alternativen Ausgestaltung könnte die Ausnehmung 11 auch gebogen oder mit einem anderen Querschnitt, insbesondere einem sich entlang der Längserstreckung H verändernden Querschnitt ausgeformt sein. Durch die geradlinige Ausgestaltung der Ausnehmung 11 ist jedoch ein einfaches Einführen des Auslöseorgans 9 gewährleistet. Die Längserstreckung H der Ausnehmung 11 ist etwa fünfmal so lang wie eine quer dazu gemessene Breite.

Auf der Platine 7 ist weiter ein Licht emittierendes Element 19 in Form einer LED angebracht. Bei Betätigung des Auslösers 8 kann durch das Licht emittierende Element 19 ein Signal an den Benutzer gegeben werden. Das Licht emittierende Element 19 kann bei Betätigung Licht aussenden. Dadurch wird signalisiert, dass sich der Sensor 2 in einem Anlernmodus befindet. Durch verschiedene Farben und/oder Signalabfolgen kann bei mehreren Anlernmodi zusätzlich signalisiert werden, in welchem der Anlernmodi sich der Sensor 2 befindet. Entsprechend kann auch eine Signalausgabe erfolgen, wenn der Sensor 2 den Anlernmodus verlässt. Das ausgesendete Licht wird durch einen Lichtleiter 20, der hier vom rechten Teil der durchgängig geschlossenen Wandung 14 gebildet ist, von innen nach außen geleitet. So kann der Benutzer von außen feststellen, ob der Auslöser 8 betätigt wurde oder nicht. Um das Licht leiten zu können, besteht der Lichtleiter 20 aus einem transparenten Material. Da das hier gezeigte Zugangselement 3 einteilig ist, besteht das gesamte Zugangselement 3 aus einem transparenten Material, in diesem Fall aus einem transparenten Kunststoff. Das Lichtleitelement 20 verläuft platzsparend neben der Ausnehmung 11 entlang. Die Richtung des Lichtleitelementes 20 verläuft parallel zur Längserstreckung H der Ausnehmung 11. Um das Licht besser bündeln oder leiten zu können, könnten noch zusätzliche Elemente etwa nach Art einer Linse angebracht sein oder vom Zugangselement 3 selbst ausgebildet werden.

Das gezeigte Zugangselement 3 wird in eine Öffnung 18 der oberen Außenseite 10 eingesetzt. In einer alternativen Ausgestaltung könnte die Basis 16 des Zugangselementes 3 so ausgestaltet sein, dass sie selbst die obere Außenseite 10 des Gehäuses bildet und mit den anderen Außenseiten 5 das Gehäuse bildet.

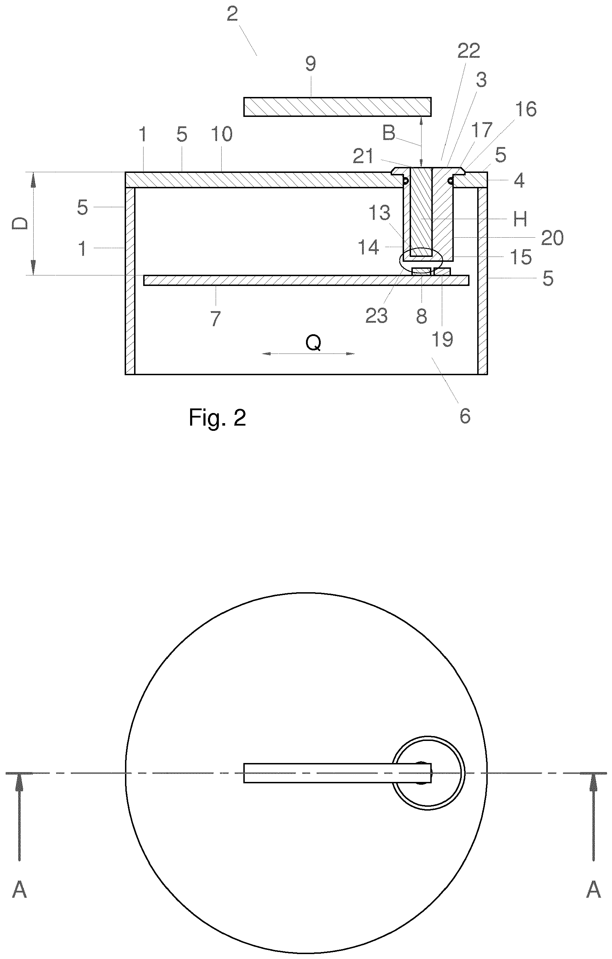

In Fig. 2 ist eine alternative Ausgestaltung eines erfindungsgemäßen Sensors 2 mit einem Gehäuse 1 dargestellt. Auch hier ist die Platine 7, auf der der Auslöser 8 angebracht ist, einen Abstand D von der Oberfläche der oberen Außenseite 10 beabstandet. Um diesen Abstand D zu überbrücken, verfügt auch die in Fig. 2 dargestellte Ausführungsform über ein Zugangselement 3. Das hier gezeigte Zugangselement 3 verfügt wieder über eine Ausnehmung 11, die sich von außen bis vor den Auslöser 8 erstreckt. In diesem Fall ist die Ausnehmung 11 jedoch mit einem Flussleitelement 21 ausgefüllt. Das Flussleitelement 21 kann das magnetische Feld eines Auslöseorgans 9 bis kurz vor den Auslöser 8 weiterleiten. Zum Betätigen des Auslösers 8 ist es daher nur notwendig, das Auslöseorgan 9 an das äußere Ende 22 des Flussleitelementes 21 zu halten. Das Flussleitelement 21 leitet das Magnetfeld dann entlang der Längserstreckung H der Ausnehmung 11 bis in den Auslösebereich 23 weiter.

Das Flussleitelement 21 kann beweglich oder unbeweglich in der Ausnehmung 11 ruhen. Es kann beispielsweise in die Ausnehmung 11 hineingeklebt sein. Alternativ kann es auch austauschbar sein.

Das hier gezeigte Flussleitelement 21 ist an seinem äußeren Ende 22 plan mit der Basis 16 des Zugangselementes 3 und der Oberfläche der oberen Außenseite 10. Alternativ dazu könnte das Flussleitelement 21 die Ausnehmung 11 auch nur teilweise ausfüllen. Dann könnte es notwendig sein, das Auslöseorgan 9 wieder teilweise in die Ausnehmung 11 einzuführen. Das Flussleitelement 21 könnte auch mit dem Rest des Zugangselementes 3 vergossen worden sein. Um ein Herausfallen dann zu verhindern, könnten Formschlusselemente am Zugangselement 3 oder am Flussleitelement 21 angebracht sein. Ferner könnte das Flussleitelement 21 auch aus der Ausnehmung 11 herausragen.

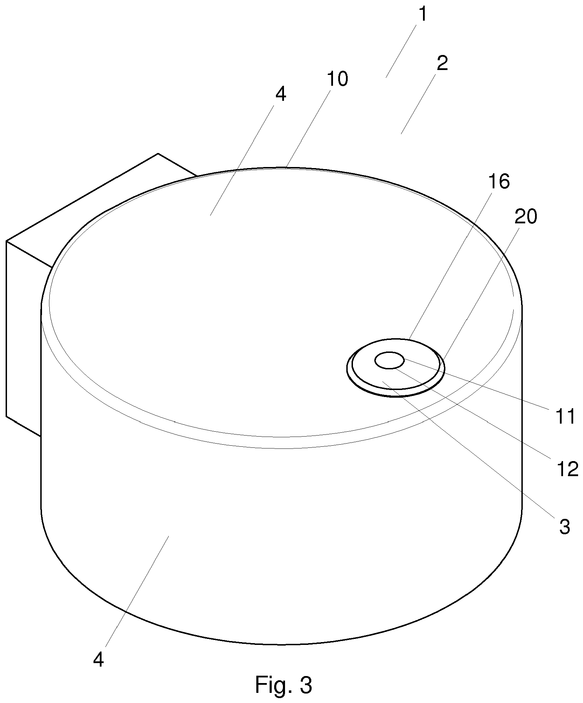

In Fig. 3 ist ein erfindungsgemäßer Sensor 2 mit einem Gehäuse 1, das ein Zugangselement 3 aufweist, dargestellt. Das Zugangselement 3 ragt in ein Inneres des Gehäuses 1. Das Innere wird in diesem Fall wieder von einem allseitig geschlossenen Innenraum 6 dargestellt. Durch die Öffnung 12 des Zugangselementes 3 kann ein Auslöseorgan 9 eingeführt werden. Dadurch wird ein Teach-In-Vorgang ausgelöst, bei dem der Sensor angelernt wird. Beispielsweise kann ein Füllstandssensor einen Voll- und einen Leerzustand gelehrt bekommen. Ein Drehgeber könnte zum Beispiel eine Nullposition gelehrt bekommen.

Sobald der Auslöser 8 betätigt wurde, wird dem Benutzer an der Basis 16 im Bereich des Lichtleiters 20 ein optisches Signal ausgegeben, mit dem der Benutzer feststellen kann, dass der Anlernzustand ausgelöst wurde. Falls es mehrere Anlernzustände gibt, kann auch angezeigt werden, welcher Anlernzustand gerade aktiv ist. Beispielsweise kann in einem ersten Anlernzustand ein Leerzustand gelehrt werden und in einem zweiten Anlernzustand ein Vollzustand gelehrt werden. Die verschiedenen Anlernzustände können beispielsweise durch verschiedene Signalfolgen oder verschiedene Farben signalisiert werden. Falls notwendig, kann nach dem Anlernen der Anlernzustand wieder deaktiviert werden, indem ein Auslöseorgan 9 in die Ausnehmung 11 eingeführt wird.

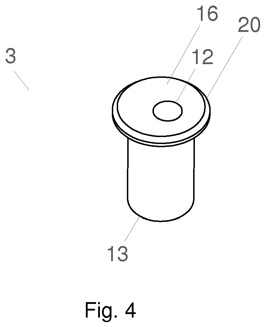

In Fig. 4 ist ein Zugangselement 3 schematisch dargestellt. In die Öffnung 12 kann ein Auslöseorgan 9 eingefügt werden. An der Basis 16 kann es an einer Außenseite 5 eines Gehäuses befestigt werden. An der Unterseite ist die Öffnung 12 gegenüberliegend ein starrer Boden angeordnet. Ferner beginnt dort der Lichtleiter 20, der sich bis zur Außenseite erstreckt.

## Patentansprüche

1. Sensor (2) mit einem Gehäuse (1), umfassend
wenigstens ein Zugangselement (3) zur Anbringung in einer Öffnung (18) des Gehäuses (1) und
einen kontaktlos betätigbaren, innerhalb des Gehäuses (1) angeordneten Auslöser (8),
wobei das Zugangselement (3) eine nach aussen offene Ausnehmung (11) mit einem starren Boden (13) ausbildet, die in das Innere des Gehäuses (1) hineinragt und der starre Boden (13) vor dem Auslöser (8) im Inneren des Gehäuses (1) liegt, wobei das Zugangselement eine durchgängig geschlossene, die Ausnehmung (11) bis auf den Boden (13) und die Öffnung (12) umschliessende Wandung (14) aufweist, wobei der starre Boden (13) mit der durchgängig geschlossenen Wandung (14) aus einem einzigen Teil besteht.

2. Sensor (2) nach Anspruch 1, bei dem das Zugangselement (3) ein Lichtleitelement (20) aufweist.

3. Sensor (2) nach einem der vorhergehenden Ansprüche, bei dem das Lichtleitelement (20) neben der Ausnehmung (11) entlang verläuft.

4. Sensor (2) nach einem der Ansprüche 2 oder 3, bei dem das Lichtleitelement (20) von einem Teil der Wandung (14) ausgebildet ist.

5. Sensor (2) nach einem der vorhergehenden Ansprüche, bei dem das Zugangselement (3) aus einem transparenten Material, insbesondere aus einem transparenten Kunststoff besteht.

6. Sensor (2) nach einem der vorhergehenden Ansprüche, bei dem die Ausnehmung (11) als Führung, insbesondere als kodierte Führung für ein Auslöseorgan (9), ausgeformt ist.

7. Sensor (2) nach einem der vorhergehenden Ansprüche, bei dem das Zugangselement (3) ein Flussleitelement (21) aufweist, das die Ausnehmung (11) zumindest teilweise, bevorzugt komplett ausfüllt.

8. Sensor (2) nach einem der vorhergehenden Ansprüche, bei dem die Ausnehmung (11) langgestreckt ist und eine Längserstreckung (H) aufweist, die von außen nach innen verläuft.

9. Sensor (2) nach einem der vorhergehenden Ansprüche, bei dem die Ausnehmung (11) langgestreckt ist und eine Längserstreckung (H) aufweist, die senkrecht zu der Außenseite (10) des Gehäuses (1) verläuft.

10. Sensor (2) nach einem der vorhergehenden Ansprüche, bei dem die Ausnehmung (11) langgestreckt ist und das Verhältnis der Länge der Längserstreckung (H) zu einer dazu senkrechten Erstreckung minimal 2:1 und maximal 50:1, bevorzugt 20:1, noch bevorzugter 10:1 beträgt.

11. Sensor (2) nach einem der vorhergehenden Ansprüche, bei dem das Zugangselement (3) eine Basis (16) aufweist, die mit einer Oberfläche des Gehäuses (1) fluchtend zusammengefügt ist.

12. Sensor (2) nach einem der vorhergehenden Ansprüche, bei dem das Zugangselement (3) eine Basis (16) aufweist, die mit der Öffnung (18) des Gehäuses (1) abdichtend zusammengefügt ist.

## Claims

1. Sensor (2) with a housing (1), comprising at least one access element (3) for mounting in an opening (18) in the housing (1) and a contactlessly operable actuator (8) located within the housing (1),
whereby the access element (3) forms a recess (11) which is open to the outside, with a rigid base (13), said recess projecting into the interior of the housing (1) and the rigid base (13) being located in front of the actuator (8) in the interior of the housing (1), whereby the access element has a continuously closed wall (14) enclosing the recess (11) as far as the base (13) and the opening (12), whereby the rigid base (13) with the continuously closed wall (14) consists of one single part.

2. Sensor (2) in accordance with Claim 1, in which the access element (3) has a light-conducting element (20).

3. Sensor (2) in accordance with one of the above Claims, in which the light-conducting element (20) runs alongside the recess (11).

4. Sensor (2) in accordance with one of the Claims 2 or 3, in which the light-conducting element (20) is formed by a part of the wall (14).

5. Sensor (2) in accordance with one of the above Claims, in which the access element (3) consists of a transparent material, in particular of a transparent plastic material.

6. Sensor (2) in accordance with one of the above Claims, in which the recess (11) is designed as a guide, in particular as a coded guide for an actuating organ (9).

7. Sensor (2) in accordance with one of the above Claims, in which the access element (3) has a flux guiding element (21) which fills out the recess (11) at least partly, preferably completely.

8. Sensor (2) in accordance with one of the above Claims, in which the recess (11) is elongated and has an elongation (H) running from the outside to the inside.

9. Sensor (2) in accordance with one of the above Claims, in which the recess (11) is elongated and has an elongation (H) running at right angles to the outside (10) of the housing (1).

10. Sensor (2) in accordance with one of the above Claims, in which the recess (11) is elongated and the ratio of the length of the elongation (H) to an elongation running at right angles to this is at least 2:1 and at most 50:1, preferably 20:1, even more preferably 10:1.

11. Sensor (2) in accordance with one of the above Claims, in which the access element (3) has a base (16) which is joined to a surface of the housing (1) in such a way that it is aligned with said surface.

12. Sensor (2) in accordance with one of the above Claims, in which the access element (3) has a base (16) which is joined to the opening (18) of the housing (1) in such a way that it forms a seal.

## Revendications

1. Détecteur (2) doté d'un boîtier (1), comprenant au moins un élément d'accès (3) destiné à être installé dans un orifice (18) du boîtier (1) et un déclencheur (8) actionnable sans contact, disposé à l'intérieur du boîtier (1),
l'élément d'accès (3) formant un évidement (11) ouvert vers l'extérieur avec un fond rigide (13), qui se prolonge à l'intérieur du boîtier (1) et le fond rigide (13) se trouve devant le déclencheur (8) à l'intérieur du boîtier (1), l'élément d'accès présentant une paroi (14) fermée en permanence, entourant l'évidement (11) jusqu'au fond (13) et l'orifice (12), le fond rigide (13) étant constitué d'une seule pièce avec la paroi (14) fermée en permanence.

2. Détecteur (2) selon la revendication 1, dans lequel l'élément d'accès (3) présente un élément de guidage de lumière (20).

3. Détecteur (2) selon l'une des revendications précédentes, dans lequel l'élément de guidage de lumière (20) s'étend en longueur à côté de l'évidement (11).

4. Détecteur (2) selon l'une des revendications 2 ou 3, dans lequel l'élément de guidage de lumière (20) est constitué d'une partie de la paroi (14).

5. Détecteur (2) selon l'une des revendications précédentes, dans lequel l'élément d'accès (3) est composé d'un matériau transparent, en particulier d'une matière plastique transparente.

6. Détecteur (2) selon l'une des revendications précédentes, dans lequel l'évidement (11) prend la forme d'un guidage, en particulier d'un guidage codé pour un organe de déclenchement (9).

7. Détecteur (2) selon l'une des revendications précédentes, dans lequel l'élément d'accès (3) présente un élément de guidage de flux (21), qui remplit au moins en partie, de préférence entièrement l'évidement (11).

8. Détecteur (2) selon l'une des revendications précédentes, dans lequel l'évidement (11) est allongé et présente une projection longitudinale (H), qui s'étend de l'extérieur vers l'intérieur.

9. Détecteur (2) selon l'une des revendications précédentes, dans lequel l'évidement (11) est allongé et présente une projection longitudinale (H), qui s'étend de manière perpendiculaire à la face extérieure (10) du boîtier (1).

10. Détecteur (2) selon l'une des revendications précédentes, dans lequel l'évidement (11) est allongé et le rapport de la longueur de la projection longitudinale (H) sur une projection perpendiculaire à celle-ci est au minimum de 2:1 et au maximum de 50:1, de préférence de 20:1, et mieux encore de 10:1.

11. Détecteur (2) selon l'une des revendications précédentes, dans lequel l'élément d'accès (3) présente une base (16), qui est assemblée en alignement à une surface du boîtier (1).

12. Détecteur (2) selon l'une des revendications précédentes, dans lequel l'élément d'accès (3) présente une base (16), qui est assemblée de manière étanche à un orifice (18).
